# EUROPEAN PATENT APPLICATION

(11) **EP 4 435 605 A1**
(43) Date of publication of application: **25.09.2024**
(21) Application number: 24163287.6
(22) Date of filing: 13.03.2024
(51) Int. Cl.: G06F 11/07

(54) **RULE-BASED FLIGHT MANAGEMENT SYSTEM LOGGING**

(30) Priority: 22.03.2023 US 202318188435
(71) Applicant: The Boeing Company, Arlington, VA 22202 (US)
(72) Inventor: VOS, Maxim Constantijn, Arlington, 22202 (US); VAN BRUCHEM, Barend-Jan, Arlington, 22202 (US); YU, Jonathan Fung Wah, Arlington, 22202 (US); BUI, Binh, Arlington, 22202 (US)
(74) Representative: Plasseraud IP

(57) **Abstract**

Techniques are provided for rule-based flight management system logging. In one aspect, the techniques involve receiving a rule set, wherein the rule set represents an indicator of a flight management system bug, error, or flight safety concern, writing log data to a first memory, wherein the log data is generated by the flight management system, and upon determining that an error indicator associated with the log data violates a rule of the rule set, writing the log data of the first memory to a second memory.

## Description

### FIELD

Aspects of the present disclosure relate to rule-based logging of flight management system data.

### BACKGROUND

Traditional logging systems for flight management system (FMS) data perform a rote recording of error data. For example, when an error manifests in the FMS data, some logging systems record prior flight management computer (FMC) button inputs, and a line of code corresponding to the error. Other logging systems record FMC data dumps and black box data.

These logging system records are used in attempts to manually replicate the errors for diagnosis after a flight. For example, a flight engineer may enter the recorded FMC button inputs into the FMC of a flight simulator in an attempt to reproduce the FMS error that was experienced during the flight. However, the amount of data logged is often voluminous and of limited relevance to replicating the error, which makes reproducing and diagnosing the error difficult, time consuming, and resource intensive.

### SUMMARY

The present disclosure provides a method in one aspect, the method including: receiving a rule set, wherein the rule set represents an indicator of a flight management system bug, error, or flight safety concern; writing log data to a first memory, wherein the log data is generated by the flight management system; and upon determining that an error indicator associated with the log data violates a rule of the rule set, writing the log data of the first memory to a second memory.

In one aspect, in combination with any example method above or below, the method includes: upon determining that the first memory is full, setting a write location of the first memory to a start location of the first memory.

In one aspect, in combination with any example method above or below, the method includes the log data written to the second memory comprising a log state, wherein the log state comprises a subset of the log data, and wherein the log state includes data from before, during, and after an occurrence of the flight management system bug, error, or flight safety concern.

In one aspect, in combination with any example method above or below, the method includes: the error indicator comprising a tag or identifier associated with the log data, wherein the error indicator notes a type of information contained in the log data.

In one aspect, in combination with any example method above or below, the method includes: simulating a flight environment; and replicating the flight management system bug, error, or flight safety concern based on the log state.

In one aspect, in combination with any example method above or below, the method includes: the simulating of the flight environment comprising at least one of: a cabin session, a software integration test environment, a desktop environment, or a virtual environment.

In one aspect, in combination with any example method above or below, the method includes: the replicating of the flight management system bug, error, or flight safety concern comprising recreating system states of a flight management system that existed before, during, or after the occurrence of the flight management system bug, error, or flight safety concern.

The present disclosure provides a system in one aspect, the system including: a processor; a memory or storage comprising an algorithm or computer instructions, which when executed by the processor, performs an operation. The operation includes: receiving a rule set, wherein the rule set represents an indicator of a flight management system bug, error, or flight safety concern; writing log data to a first memory, wherein the log data is generated by the flight management system; and upon determining that an error indicator associated with the log data violates a rule of the rule set, writing the log data of the first memory to a second memory.

In one aspect, in combination with any example operation above or below, the operation includes: upon determining that the first memory is full, setting a write location of the first memory to a start location of the first memory.

In one aspect, in combination with any example operation above or below, the operation includes the log data written to the second memory comprising a log state, wherein the log state comprises a subset of the log data, and wherein the log state includes data from before, during, and after an occurrence of the flight management system bug, error, or flight safety concern.

In one aspect, in combination with any example operation above or below, the operation includes: the error indicator comprising a tag or identifier associated with the log data, wherein the error indicator notes a type of information contained in the log data.

In one aspect, in combination with any example operation above or below, the operation includes: simulating a flight environment; and replicating the flight management system bug, error, or flight safety concern based on the log state.

In one aspect, in combination with any example operation above or below, the operation includes: the simulating of the flight environment comprising at least one of: a cabin session, a software integration test environment, a desktop environment, or a virtual environment.

In one aspect, in combination with any example operation above or below, the operation includes: the replicating of the flight management system bug, error, or flight safety concern comprising recreating system states of a flight management system that existed before, during, or after the occurrence of the flight management system bug, error, or flight safety concern.

The present disclosure provides a non-transitory computer-readable storage medium in one aspect, the non-transitory computer-readable storage medium having computer-readable program code embodied therewith, the computer-readable program code executable by one or more computer processors to perform an operation. The operation includes: receiving a rule set, wherein the rule set represents an indicator of a flight management system bug, error, or flight safety concern; writing log data to a first memory, wherein the log data is generated by the flight management system; and upon determining that an error indicator associated with the log data violates a rule of the rule set, writing the log data of the first memory to a second memory.

In one aspect, in combination with any example operation above or below, the operation includes: upon determining that the first memory is full, setting a write location of the first memory to a start location of the first memory.

In one aspect, in combination with any example operation above or below, the operation includes the log data written to the second memory comprising a log state, wherein the log state comprises a subset of the log data, and wherein the log state includes data from before, during, and after an occurrence of the flight management system bug, error, or flight safety concern.

In one aspect, in combination with any example operation above or below, the operation includes: the error indicator comprising a tag or identifier associated with the log data, wherein the error indicator notes a type of information contained in the log data.

In one aspect, in combination with any example operation above or below, the operation includes: simulating a flight environment; and replicating the flight management system bug, error, or flight safety concern based on the log state.

In one aspect, in combination with any example operation above or below, the operation includes: the replicating of the flight management system bug, error, or flight safety concern comprising recreating system states of a flight management system that existed before, during, or after the occurrence of the flight management system bug, error, or flight safety concern.

### BRIEF DESCRIPTION OF THE DRAWINGS

So that the manner in which the above recited features can be understood in detail, a more particular description, briefly summarized above, may be had by reference to example aspects, some of which are illustrated in the appended drawings.
Fig. 1 illustrates a flight management system model, according to one aspect of the present disclosure.
Fig. 2 illustrates a flight management computer environment, according to one aspect of the present disclosure.
Fig. 3 illustrates a flowchart of a method of capturing a log state, according to one aspect of the present disclosure.
Fig. 4 a flowchart of a method of replicating an issue, according to one aspect of the present disclosure.

### DETAILED DESCRIPTION

The present disclosure provides improved FMS logging by using rule sets to automate the logging of data pertinent to in-flight FMS bugs and errors. In one aspect of the present disclosure, a logging module uses predetermined rule sets to automatically capture logging data that result from, or provide context to, the FMS bugs and errors. In this manner, logging data that is irrelevant to the FMS bugs and errors is not captured. Flight engineers can use the captured logging data to replicate and diagnose the FMS bugs and errors in flight simulations.

One benefit of aspects of the present disclosure is to provide improved outcomes in reproducing in-flight FMS bugs and errors in a simulation by capturing more relevant logging data. Further, aspects of the present disclosure can improve the efficiency of the reproduction process by decreasing the volume of irrelevant captured logging data, thereby saving computing resources (e.g., storage) and enabling faster execution of the computing resource by ignoring irrelevant data.

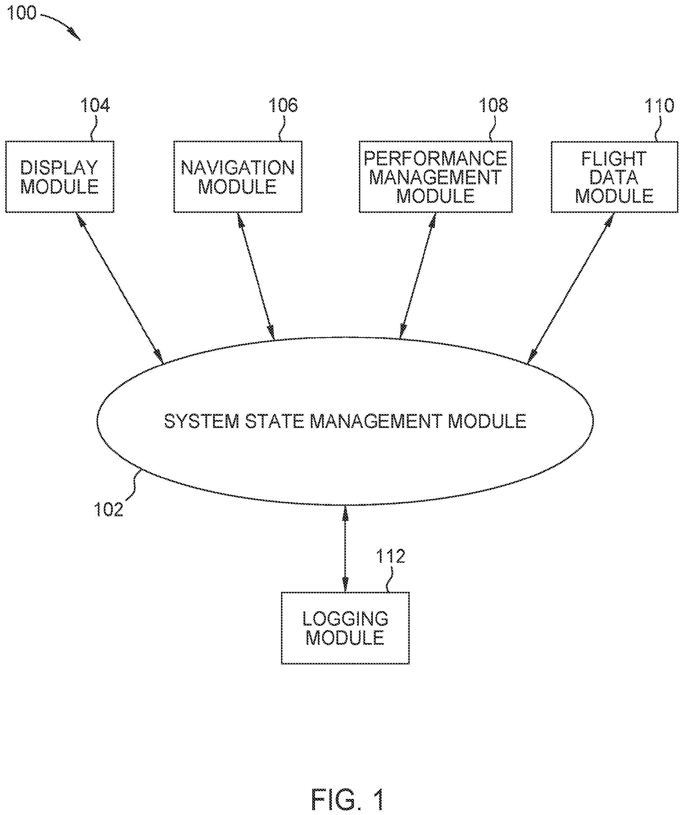

Fig. 1 illustrates a flight management system model 100, according to one aspect of the present disclosure. In one aspect, an FMS is a control system that executes and monitors flight paths. The FMS can also manage information from numerous aircraft systems, and communicate with air traffic control to optimize the flight plan for safety and efficiency, and to reduce the workload of the flight crew.

The FMS model illustrated in Fig. 1 depicts a software representation of an FMS. Each of the illustrated modules represents one or more algorithms, instruction sets, software applications, or other computer-readable program code residing in a memory or storage, and can be executed by a processor to perform the functions or processes described herein. Not all features of the FMS are shown.

In the aspect illustrated in Fig. 1, a system state management (SSM) module 102 generates and manages a system state of an aircraft based on data from a display module 104, navigation module 106, performance management module 108, and flight data module 110. The SSM module 102 can also transfer the data and the system state to a logging module 112, which records the data as described herein.

The display module 104 includes information transferred between the SSM module 102 and display systems in the cockpit of the aircraft. The display systems in the cockpit can include a control display unit (CDU) and an electronic flight instrument system (EFIS).

In one aspect of the present disclosure, the CDU includes a console with input buttons and a screen interface that allow a pilot to enter data and commands into the SSM module 102. The pilot can use the CDU to communicate with air traffic control, which enables the SSM module 102 to automatically guide the aircraft along a predetermined flight path included in a flight plan.

The EFIS can include multiple displays that provide a comprehensive overview of the systems of the aircraft, such as navigation, communication, and flight control. For example, the EFIS can include a navigation display, performance display, primary flight display, and the like.

The navigation module 106 can use on-board distance measuring equipment and predetermined location data to generate navigation information such as the position of the aircraft, flight path distances, and distances between the aircraft and target destinations. The navigation module 106 can also generate or supplement the navigation information using navigation systems such as very high frequency omnidirectional range systems (VORs) and GPS. The navigation information can be transferred to the navigation display to provide the pilot with distance, location, and route information related to the flight.

In one aspect, the performance management module 108 maintains a database of predetermined flight metrics, and uses the predetermined flight metrics to determine an optimal airspeed. Examples of the predetermined include: the weight of the aircraft, electrical power output values, fuel consumption rates, hydraulic pressure levels, thrust output values, and the like. The performance management module 108 can also consider environmental data, such as weather conditions (temperature, wind speed and direction, precipitation, cloud cover, turbulence, and the like) and weather forecasts. The performance information can be transferred to the performance display to provide the pilot with the optimal airspeed, flight metrics, warning messages, and the like.

In one aspect, the flight data module 110 maintains flight information used by other modules of the FMS. For example, the flight data module 110 can maintain original and modified flight plans, and calculate present values for airspeed, altitude, attitude, trajectories, vertical speed, and the like. The flight data information can be transferred to the primary flight display, or to any of the other modules to provide the pilot with the aforementioned information.

The logging module 112 records logging data that indicates in-flight FMS bugs and errors. In addition to logging the navigation information, performance information, and flight data information, the logging module 112 can also log related aircraft safety or concern data, aircraft state data, and built-in self-test (BITE) data.

Examples of aircraft safety or concern data include: navigation issues, such as deviations from the flight plan; communication issues, such as problems with radio transmission or reception; performance issues such as engine malfunctions, excessive fuel consumption; alerts or warnings generated by the aircraft crew, such as low fuel alerts or system failures; air traffic control communication, such as communications about clearances and instructions; and adverse environmental conditions, such as turbulence, icing, or thunderstorms.

In one aspect of the present disclosure, the aircraft state comprises variables and validity signals that represent a snapshot of a state space of the aircraft. The variables can include, for example, altitude, calibrated airspeed, ground speed, Mach speed, pitch angle, cabin pressure, roll angle, weight, and the like. The variables can also include state representations of systems of the aircraft. For example, one state representation may indicate whether or not, at a given timestamp, a retractable landing gear of the aircraft has been engaged, or has completed the retraction process. Another state representation may indicate a value, at a given timestamp, of an internal signal, such as a counter or a latch. The validity signals can indicate whether values of the variables are within expected or acceptable ranges
In one aspect, the BITE is an electronics self-testing and diagnostic system that is built into avionics systems of the aircraft. A BITE dump is a diagnostic report generated by the tests performed by the BITE system. The BITE dump can include information about detected faults or failures of the avionics systems, which can be used by maintenance personnel for diagnosis and repair. Examples of BITE dumps include NAV dumps, flight management function (FMF) dumps, and thrust management function (TMF) dumps.

NAV dumps can refer to the reports generated using information from the BITE of a navigation system of the aircraft. The NAV dump can include diagnostic information about the performance of the navigation system, such as the ability of the navigation system to track the position, altitude, heading, and airspeed of the aircraft.

FMF dumps can refer to the reports generated using information from the BITE of performance, guidance, and trajectory prediction systems of the aircraft. The FMF dump can include diagnostic information about expected performance, location tracking, location projections (e.g., predicted lateral and vertical trajectories), and deviations therefrom.

TMF dumps can refer to the reports generated using information from the BITE of engine control systems of the aircraft. The TMF dump can include diagnostic information about engine inputs, measurements, outputs, and responsiveness.

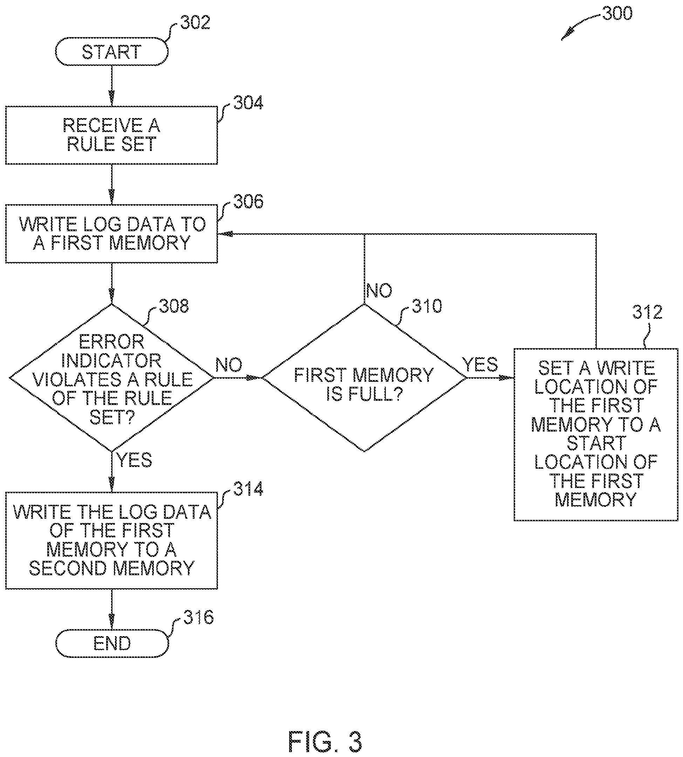

In one aspect, the logging module 112 recreate aspects of the system state generated by the SSM module 102, such that the in-flight FMS bugs and errors can be reproduced and diagnosed in a post-flight simulation. This process is described in greater detail in Figs. 3-4 below.

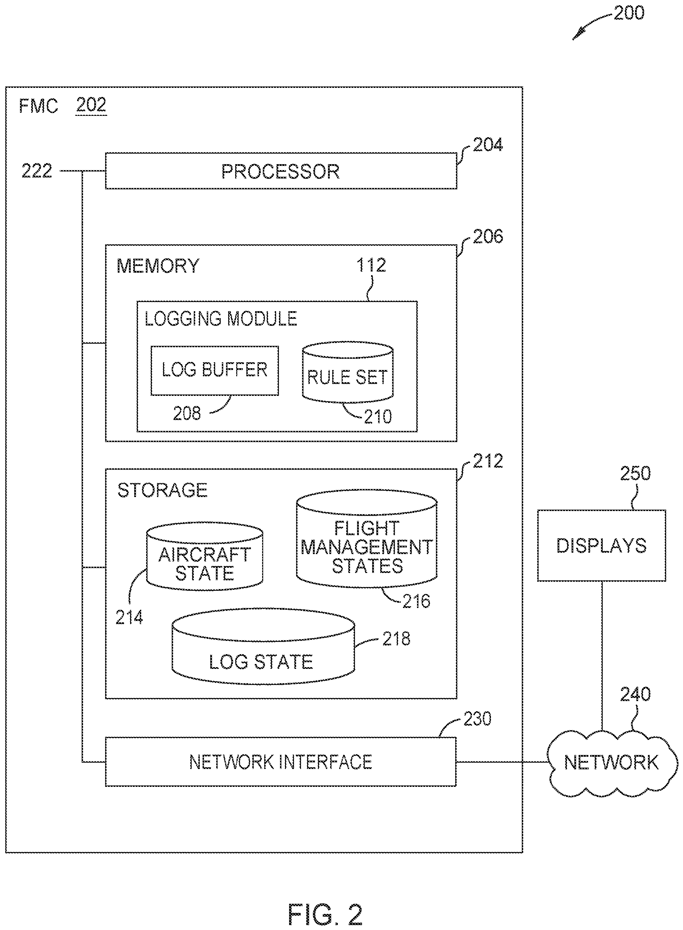

Fig. 2 illustrates a flight management computer environment 200, according to one aspect of the present disclosure. In one aspect, the flight management computer environment 200 includes an FMC 202, network 240, and displays 250.

In one example of the present disclosure, the FMC 202 is a computer system that executes the flight management system model 100. The FMC can be generally be used to execute tasks of the FMS. For example, the FMC 202 can process the flight data and display data, execute a flight plan, execute auto-pilot features, log FMS data, and the like.

The FMC 202 illustrated in Fig. 2 includes a processor 204 that obtains instructions and data via a bus 222 from memory 206 or storage 212. Not all features of the FMC 202 are shown. The processor 204 is a programmable logic device that performs instruction, logic, and mathematical processing, and may be representative of one or more CPUs.

As previously discussed, each module of the flight management system model 100 (e.g., logging module 112) represents one or more algorithms, instruction sets, or software applications. These modules can reside in memory 206 or storage 212, and can be executed by the processor 204 to perform the functions or processes described herein.

The memory 206 and storage 212 can be representative of non-transitory computer-readable storage mediums, such as hard-disk drives, solid state drives, flash memory devices, optical media, and the like. The storage 212 can also include structured storage (e.g., a database). In addition, the memory 206 and storage 212 may be considered to include memory physically located elsewhere. For example, the memory 206 or storage 212 can be located on another computing system coupled to the FMC 202.

The FMC 202 can be connected to other computing systems (e.g., distributed databases, servers, or web-hosts), devices, or displays 250 via a network interface 230 and network 240. The network 240 can include any combination of electrical bus, physical transmission cables, optical transmission fibers, wireless transmission, routers, firewalls, switches, gateway computing systems and/or edge servers. The network 240 can also comprise, for example, a local area network, a wide area network, or a wireless network. The network interface 230 may be any type of network communications device allowing the FMC 202 to communicate with other computing systems or devices via the network 240. In one aspect, the displays 250 comprise the CDU and EFIS.

In one aspect of the present disclosure, the logging module 112 generally creates logs, or records, of in-flight data generated via the flight management system model 100. For example, performance data logged from the performance management module 108 can be used to monitor fuel consumption, engine performance, and other key performance or safety parameters. Navigation information logged from the navigation module 106 can be used to assess the flight path, including the route taken, altitude, and speed. Communication data logged from the navigation module 106, or the flight data module 110, can provide information about communication failures or interference encountered during the flight. This logged data can be used to conduct post-flight analysis and diagnosis, and to improve future flight performance and safety.

In the example illustrated in Fig. 2, the logging module 112 writes data to log buffer 208. Afterwards, the logging module 112 writes a subset of the data to log state 220 based on a comparison of a rule set 210 to data in the log buffer 208. The data is written to log state 220 can be used to recreate aspects of the flight management states 216 in a post-flight simulation, such that FMS bugs and errors reflected in the logged data can be replicated and diagnosed. This process is described in further detail in Figs. 3-4 below.

Fig. 3 illustrates a flowchart of a method 300 of capturing a log state, according to one aspect of the present disclosure. In one aspect, the method 300 is an operation performed by the logging module 112. The method 300 begins at block 302.

At block 304, the logging module 112 receives a rule set. In one aspect of the present disclosure, rules in the rule set represent an indicator of an FMS bug, error, or other flight related safety concern. The rules can be defined by subject matter experts on flight management systems, and aircraft and flight safety. In the aspect illustrated in Fig. 2, the rules are input into the logging module 112 as rule set 210.

Examples of the rules include: flight phase changes between takeoff, climb, cruise, descent, and approach; aircraft transitions between ground and air on takeoff or landing; modification of flight plan routes; absence of trajectory predictions of a leg of a flight plan; multiple toggling between predictions of lateral or vertical trajectories; delayed time or arrival solutions; FMS warning messages; unexpected visual artifacts on the displays 250, and the like.

As described below, the rules aid in the logging of data relevant to FMS bugs and errors, while reducing or eliminating the logging of data that is not of interest. Hence, data logged via the method 300 may contain a subset of all data available to be logged.

One benefit to using the method 300 is that the volume of data logged is reduced in comparison to traditional logging methods. Hence, the limited storage capacity of on-board memory is not an impediment to the logging module 112. Further, because much less data may be logged, the time required to copy, process, and utilize the data may be drastically reduced, thereby improving the efficiency of the computing resources.

At block 306, the logging module 112 writes log data to a first memory. As describe above, the log data can be any data generated via the flight management system model 100.

In the example illustrated in Fig. 2, the first memory is log buffer 208. However, the first memory can be any memory or storage. For instance, the first memory can be representative of caches, registers, flash memory devices, solid state drives, databases, hard-disk drives, optical media, and the like. In addition, the first memory may be considered to include memory or storage physically located elsewhere from the FMC 202. In one aspect, the first memory storage is a non-transitory, temporary computer-readable storage medium.

At block 308, the logging module 112 determines whether an error indicator violates a rule of the rule set. In one aspect, the error indicator comprises a tag or identifier that is associated with the log data. For example, the error indicator can be a sequence of data at the beginning of each log data entry, or metadata associated with each log data entry, that notes the type of information contained in the log data entry. In one aspect, a module of the flight management system model 100 generates the error identifier when generating the data related to the FMS bug, error, or flight safety concern.

The logging module 112 can compare the error indicator of each log data entry to each rule in the rule set. Upon determining that the error indicator does not violate a rule of the rule set, the method 300 proceeds to block 310.

At block 310, the logging module 112 determines whether the first memory is full. Upon determining that the first memory is not full, the method 300 proceeds to block 306, where the logging module 112 stores log data in the first memory as described above. However, upon determining that the first memory is full, the method 300 proceeds to block 312, where the logging module 112 sets a write location of the first memory to the start of the first memory.

For example, assuming that the first memory is represented as a memory stack beginning at memory location 1 and ending at memory location 10, the logging module 112 can write log data to the first memory starting at memory location 1, and then write to each successive memory location until after writing to memory location 10. When the logging module 112 determines that memory locations 1-10 are full, the logging module 112 can reset the writing location to memory location 1, and overwrite the data in the first memory beginning at memory location 1 and ending at memory location 10.

In the example illustrated in Fig. 2, the logging module 112 continuously writes the log data to the log buffer 208. When the log buffer 208 is full, the logging module 112 overwrites log data starting at the beginning of the log buffer 208.

The method 300 then proceeds to block 306, where the logging module 112 performs as described above. In this manner, the logging module 112 continuously writes log data to the first memory until the error indicator violates a rule of the rule set at block 308.

Returning to block 308, upon determining that the error indicator violates a rule of the rule set, the method 300 proceeds to block 314. At block 314, the logging module 112 writes the log data of the first memory to a second memory. In this manner, because a violation of a rule triggers a transfer of the log data to the second memory, each rule of the rule set defines the type of data that is written to the second memory.

In the example illustrated in Fig. 2, the second memory is storage 212. However, the second memory can be any memory or storage. For instance, the second memory can be representative of buffers, caches, registers, databases, hard-disk drives, solid state drives, flash memory devices, optical media, and the like. In addition, the second memory may be considered to include memory or storage physically located elsewhere from the FMC 202.

As mentioned above, the logging module 112 continuously writes, and overwrites, log data to the log buffer 208 from the beginning to the end of the log buffer 208. In this manner, when the log data in the log buffer 208 is written to the second memory, the transferred log data includes information from before, during, and after the error indicator violated the rule, which corresponds to information from before, during, and after the occurrence of an FMS bug, error, or other flight related safety concern. Therefore, the log data that is written to the second memory can provide contextual information useful for replicating, assessing, and diagnosing the FMS bug, error, or flight safety concern.

In the example illustrated in Fig. 2, when the logging module 112 determines that the error indicator of a log data entry violates a rule of the rule set, the logging module captures a snapshot of the log buffer 208. This snapshot is stored as the log state 218. The method 300 ends at block 316.

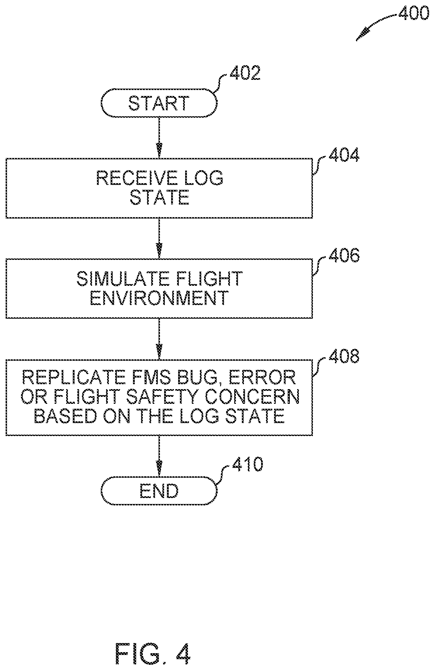

Fig. 4 a flowchart of a method 400 of replicating an issue, according to one aspect of the present disclosure. In one aspect, the method 400 can be performed via a flight engineering software (e.g., a software integration test environment (SITE) software, flight planning software, or FMS software). The method 400 begins at block 402.

At block 404, the flight engineering software receives the log state 218. In one aspect, of the present disclosure, the log state 218 is received post-flight, such that the log state 218 includes log data from before, during, and after each in-flight FMS bug, error, or flight safety concern.

At block 406, the flight engineering software simulates a flight environment. Examples of the simulated flight environment includes cabin sessions, a SITEs, and desktop or virtual environments. In one aspect, a cabin session refers to a physical and software hybrid simulation of the aircraft cabin comprising a physical structure that allows for a movable or stationary experience of the cabin during a simulated software flight experience. In one aspect, the SITE provides a software simulation of systems in the aircraft, such as the flight management system model 100 and the displays 250.

At block 408, the flight engineering software replicates the FMS bug, error, or flight safety concern based on the log state 218. During the flight simulation, the flight engineering software can use the log data in the second memory to reproduce the FMS bug, error, or aircraft safety concern by recreating the conditions that created the log data. In one aspect, the log data includes relevant inputs into the flight management system model 100, which can be entered into the simulation to replicate the pertinent issues.

In one aspect, the log data includes data from the system state management (SSM) module 102, which includes the variables and values of each module of the flight management system model 100 at the time the FMS bug, error, or flight safety concern was detected. The flight engineering software can use the variables and values of each module to recreate system states of the SSM module 102 (e.g., flight management states 216) that existed before, during, or after the occurrence of the FMS bug, error, or flight safety concern.

In this manner, the flight engineering software can track and isolate the emergence of each FMS bug, error, or flight safety concern as outcomes of changes between the system states. The tracking and isolation of these issues improves the ability of flight engineers to assess, diagnose, and resolve the FMS bugs, errors, or flight safety concerns noted in the log state 218. The method 400 ends at block 410.

In the current disclosure, reference is made to various aspects. However, it should be understood that the present disclosure is not limited to specific described aspects. Instead, any combination of the following features and elements, whether related to different aspects or not, is contemplated to implement and practice the teachings provided herein. Additionally, when elements of the aspects are described in the form of "at least one of A and B," it will be understood that aspects including element A exclusively, including element B exclusively, and including element A and B are each contemplated. Furthermore, although some aspects may achieve advantages over other possible solutions and/or over the prior art, whether or not a particular advantage is achieved by a given aspect is not limiting of the present disclosure. Thus, the aspects, features, aspects and advantages disclosed herein are merely illustrative and are not considered elements or limitations of the appended claims except where explicitly recited in a claim(s). Likewise, reference to "the invention" shall not be construed as a generalization of any inventive subject matter disclosed herein and shall not be considered to be an element or limitation of the appended claims except where explicitly recited in a claim(s).

As will be appreciated by one skilled in the art, aspects described herein may be embodied as a system, method or computer program product. Accordingly, aspects may take the form of an entirely hardware aspect, an entirely software aspect (including firmware, resident software, micro-code, etc.) or an aspect combining software and hardware aspects that may all generally be referred to herein as a "circuit," "module" or "system." Furthermore, aspects described herein may take the form of a computer program product embodied in one or more computer readable storage medium(s) having computer readable program code embodied thereon.

Program code embodied on a computer readable storage medium may be transmitted using any appropriate medium, including but not limited to wireless, wireline, optical fiber cable, RF, etc., or any suitable combination of the foregoing.

Computer program code for carrying out operations for aspects of the present disclosure may be written in any combination of one or more programming languages, including an object oriented programming language such as Java, Smalltalk, C++ or the like and conventional procedural programming languages, such as the "C" programming language or similar programming languages. The program code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present disclosure are described herein with reference to flowchart illustrations and/or block diagrams of methods, apparatuses (systems), and computer program products according to aspects of the present disclosure. It will be understood that each block of the flowchart illustrations and/or block diagrams, and combinations of blocks in the flowchart illustrations and/or block diagrams, can be implemented by computer program instructions. These computer program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the block(s) of the flowchart illustrations and/or block diagrams.

These computer program instructions may also be stored in a computer readable medium that can direct a computer, other programmable data processing apparatus, or other device to function in a particular manner, such that the instructions stored in the computer readable medium produce an article of manufacture including instructions which implement the function/act specified in the block(s) of the flowchart illustrations and/or block diagrams.

The computer program instructions may also be loaded onto a computer, other programmable data processing apparatus, or other device to cause a series of operational steps to be performed on the computer, other programmable apparatus or other device to produce a computer implemented process such that the instructions which execute on the computer, other programmable data processing apparatus, or other device provide processes for implementing the functions/acts specified in the block(s) of the flowchart illustrations and/or block diagrams.

Also provided are the following illustrative, non-exhaustive further examples of the subject matter encompassed herein, which relate to:

A method, comprising: receiving a rule set, wherein the rule set represents an indicator of a flight management system bug, error, or flight safety concern; writing log data to a first memory, wherein the log data is generated by the flight management system; and upon determining that an error indicator associated with the log data violates a rule of the rule set, writing the log data of the first memory to a second memory.

In embodiments of the method described in the immediately preceding paragraph, the method may further comprise upon determining that the first memory is full, setting a write location of the first memory to a start location of the first memory.

In embodiments of the method described in the first paragraph of the two immediately preceding paragraphs, the log data written to the second memory may comprise a log state, the log state comprising a subset of the log data, and the log state may include data from before, during, and after an occurrence of the flight management system bug, error, or flight safety concern.

In embodiments of the method described in the first paragraph of the three immediately preceding paragraphs, the error indicator may comprise a tag or identifier associated with the log data, and the error indicator may note a type of information contained in the log data.

In embodiments of the method described in the first of the two immediately preceding paragraphs, the proposed method may further comprise: simulating a flight environment; and replicating the flight management system bug, error, or flight safety concern based on the log state.

In embodiments of the method described in the immediately preceding paragraph, simulating the flight environment may include at least one of: a cabin session, a software integration test environment, a desktop environment, or a virtual environment.

In embodiments of the method described in the first of the two immediately preceding paragraphs, replicating the flight management system bug, error, or flight safety concern may comprise recreating system states of a flight management system that existed before, during, or after the occurrence of the flight management system bug, error, or flight safety concern.

A system, comprising: a processor; a memory or storage comprising an algorithm or computer instructions, which when executed by the processor, performs an operation comprising: receiving a rule set, wherein the rule set represents an indicator of a flight management system bug, error, or flight safety concern; writing log data to a first memory, wherein the log data is generated by the flight management system; and upon determining that an error indicator associated with the log data violates a rule of the rule set, writing the log data of the first memory to a second memory.

In embodiments of the system described in the immediately preceding paragraph, the operation may further comprise upon determining that the first memory is full, setting a write location of the first memory to a start location of the first memory.

In embodiments of the system described in the first of the two immediately preceding paragraphs, the log data written to the second memory may comprise a log state, the log state may comprise a subset of the log data, and the log state may include data from before, during, and after an occurrence of the flight management system bug, error, or flight safety concern.

In embodiments of the system described in the first of the three immediately preceding paragraphs, the error indicator may comprise a tag or identifier associated with the log data, and the error indicator may note a type of information contained in the log data.

In embodiments of the system described in the first of the two immediately preceding paragraphs, the system may further be configured for: simulating a flight environment; and replicating the flight management system bug, error, or flight safety concern based on the log state.

In embodiments of the system described in the immediately preceding paragraph, simulating the flight environment may include at least one of: a cabin session, a software integration test environment, a desktop environment, or a virtual environment.

In embodiments of the system described in the first of the two immediately preceding paragraphs, replicating the flight management system bug, error, or flight safety concern may comprise recreating system states of a flight management system that existed before, during, or after the occurrence of the flight management system bug, error, or flight safety concern.

A non-transitory computer-readable storage medium having computer-readable program code embodied therewith, the computer-readable program code executable by one or more computer processors to perform an operation comprising: receiving a rule set, wherein the rule set represents an indicator of a flight management system bug, error, or flight safety concern; writing log data to a first memory, wherein the log data is generated by the flight management system; and upon determining that an error indicator associated with the log data violates a rule of the rule set, writing the log data of the first memory to a second memory.

In embodiments of the non-transitory computer-readable storage medium described in the immediately preceding paragraph, the operation may further comprise upon determining that the first memory is full, setting a write location of the first memory to a start location of the first memory.

In embodiments of the non-transitory computer-readable storage medium described in the first of the two immediately preceding paragraphs, the log data written to the second memory may comprise a log state, the log state may comprise a subset of the log data, and the log state may include data from before, during, and after an occurrence of the flight management system bug, error, or flight safety concern.

In embodiments of the non-transitory computer-readable storage medium described in the first of the three immediately preceding paragraphs, the error indicator may comprise a tag or identifier associated with the log data, and the error indicator may note a type of information contained in the log data.

In embodiments of the non-transitory computer-readable storage medium described in the first of the two immediately preceding paragraphs, the operation may further comprise: simulating a flight environment; and replicating the flight management system bug, error, or flight safety concern based on the log state.

In embodiments of the non-transitory computer-readable storage medium described in the immediately preceding paragraph, replicating the flight management system bug, error, or flight safety concern may comprise recreating system states of a flight management system that existed before, during, or after the occurrence of the flight management system bug, error, or flight safety concern.

The flowchart illustrations and block diagrams in the Figures illustrate the architecture, functionality, and operation of possible implementations of systems, methods, and computer program products according to various aspects of the present disclosure. In this regard, each block in the flowchart illustrations or block diagrams may represent a module, segment, or portion of code, which comprises one or more executable instructions for implementing the specified logical function(s). It should also be noted that, in some alternative implementations, the functions noted in the block may occur out of the order noted in the Figures. For example, two blocks shown in succession may, in fact, be executed substantially concurrently, or the blocks may sometimes be executed in the reverse order or out of order, depending upon the functionality involved. It will also be noted that each block of the block diagrams and/or flowchart illustrations, and combinations of blocks in the block diagrams and/or flowchart illustrations, can be implemented by special purpose hardware-based systems that perform the specified functions or acts, or combinations of special purpose hardware and computer instructions.

While the foregoing is directed to aspects of the present disclosure, other and further aspects of the disclosure may be devised without departing from the basic scope thereof, and the scope thereof is determined by the claims that follow.

## Claims

1. A method, comprising:
receiving (304) a rule set, wherein the rule set represents an indicator of a flight management system bug, error, or flight safety concern;
writing (306) log data to a first memory, wherein the log data is generated by the flight management system; and
upon determining that an error indicator associated with the log data violates a rule of the rule set, writing (314) the log data of the first memory to a second memory.

2. The method of claim 1, further comprising:
upon determining that the first memory is full, setting (312) a write location of the first memory to a start location of the first memory.

3. The method of claim 1, wherein the log data written to the second memory comprises a log state (218), wherein the log state comprises a subset of the log data, and wherein the log state includes data from before, during, and after an occurrence of the flight management system bug, error, or flight safety concern.

4. The method of claim 1, wherein the error indicator comprises a tag or identifier associated with the log data, and wherein the error indicator notes a type of information contained in the log data.

5. The method of claim 3, further comprising:
simulating (406) a flight environment; and
replicating (408) the flight management system bug, error, or flight safety concern based on the log state.

6. The method of claim 5, wherein simulating the flight environment includes at least one of: a cabin session, a software integration test environment, a desktop environment, or a virtual environment.

7. The method of claim 5, wherein replicating the flight management system bug, error, or flight safety concern comprises recreating system states of a flight management system that existed before, during, or after the occurrence of the flight management system bug, error, or flight safety concern.

8. A system (200), comprising:
a processor (204);
a memory or storage (206) comprising an algorithm or computer instructions, which when executed by the processor, performs operations according to the method of claim 1.

9. The system of claim 8, wherein the operations further comprise operations according to the method of any of claims 2 to 7.

10. A non-transitory computer-readable storage medium having computer-readable program code embodied therewith, the computer-readable program code executable by one or more computer processors to perform operations according to the method of claim 1.

11. The non-transitory computer-readable storage medium of claim 10, wherein the operations further comprise operations according to the method of any of claims 2 to 7.
